(19) Europäisches Patentamt
European Patent Office
Office européen des brevets

(11) **EP 2 296 280 B1**

(12) **EUROPEAN PATENT SPECIFICATION**

(45) Date of publication and mention
of the grant of the patent:
**19.12.2012 Bulletin 2012/51**

(51) Int Cl.:
***H03M 1/12*** *(2006.01)*      *H03M 1/46* *(2006.01)*

(21) Application number: **10152283.7**

(22) Date of filing: **01.02.2010**

(54) **Asynchronous SAR ADC**

Asynchroner ADW mit schrittweiser Annäherung

CAN SAR asynchrone

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **10.09.2009 US 241224 P**

(43) Date of publication of application:
**16.03.2011 Bulletin 2011/11**

(73) Proprietor: **Stichting IMEC Nederland
5656 AE Eindhoven (NL)**

(72) Inventor: **HARPE, Pieter
5615 RK, Eindhoven (NL)**

(74) Representative: **Sarlet, Steven Renaat Irène et al
Gevers
Intellectual Property House
Holidaystraat 5
1831 Diegem (BE)**

(56) References cited:
• **KINNIMENT D J ET AL: "Towards asynchronous A-D conversion" ADVANCED RESEARCH IN ASYNCHRONOUS CIRCUITS AND SYSTEMS, 1998. PROCEEDI NGS. 1998 FOURTH INTERNATIONAL SYMPOSIUM ON SAN DEIGO, CA, USA 30 MARCH-2 APRIL 1998, LOS ALAMITOS, CA, USA,IEEE COMPUT. SOC, US LNKD- DOI:10.1109/ASYNC.1998.666506, 30 March 1998 (1998-03-30), pages 206-215, XP010274562 ISBN: 978-0-8186-8392-3**
• **GIANNINI V ET AL: "An 820 W 9b 40MS/s Noise-Tolerant Dynamic-SAR ADC in 90nm Digital CMOS",SOLID-STATE CIRCUITS CONFERENCE, 2008. ISSCC 2008. DIGEST OF TECHNICAL PAPERS. IEEE INTERNATIONAL, IEEE, PISCATAWAY, NJ, USA, 3 February 2008 (2008-02-03), pages 238-239,610, XP031390947, ISBN: 978-1-4244-2010-0**

## Description

## FIELD OF THE INVENTION

This invention relates generally to analog-to-digital converters, in particular to asynchronous successive approximation analog to digital convertors.

The invention also relates to an electronic device comprising such an analog to digital convertor.

## DESCRIPTION OF RELATED ART

An analog-to-digital converter (ADC) is a common building block of modern integrated circuits. It is commonly used to sample an analog signal and convert it into digital values, which can e.g. be used for further digital processing. Different architectures are in use today to meet a wide range of requirements, e.g. linearity, conversion speed, noise, or power consumption. Examples of ADC architectures are e.g. flash ADC, linear approximation ADC, successive approximation ADC (SAR), sigma delta ADC, and others.

Successive approximation ADC is the name commonly given to an analog-to-digital conversion process in which digital approximations of the input analog voltage are determined on the basis of a binary search. A digital value stored in an n-bit successive approximation register (SAR) is input to a digital-to-analog converter, and a decision is made as to whether the value in the SAR represents an analog voltage that is higher or lower than the input analog value. The initial value of the SAR is conventionally set to one-half the number that can be represented in the n bits of the SAR. To be more precise, an n-bit register can contain a value of $2^n$-1, but for purposes of successive approximation, the initial value has the most significant bit set and the others cleared, which translates into a value of $2^n/2$. If this comparison reveals that the digital approximation is indeed lower than the input voltage, the bit that was initially set remains set, the bit of next lower significance is also set, and another trial commences. If on the other hand, the SAR value is greater than the input analog voltage, the bit that was set for that trial is cleared, the bit of next lower significance is set, and another trial commences. It can be appreciated from this example why a successive approximation approach bears such a similarity to a binary search procedure. Each bit of the SAR is set or cleared based upon a trial, so the analog to digital conversion process requires only "n" trials to reach completion. A conventional SAR converter consists of only a DAC (digital-to-analog converter), a SAR register, control logic, and a single comparator. To generate an N-bit conversion result, each component of the converter is used (or updated) N times in a series of what are known as bit trials.

One of the most common implementations of the successive approximation ADC, the charge-redistribution successive approximation ADC, uses a charge scaling DAC. The charge scaling DAC simply consists of an array of individually switched binary-weighted capacitors. The amount of charge upon each capacitor in the array is used to perform the aforementioned binary search in conjunction with a comparator internal to the DAC and the successive approximation register.

A disadvantage of traditional SAR ADC's is that a large number of clock cycles are necessary to implement a single n-bit conversion, resulting in a complicated state-machine running at a highly oversampled clock dissipating a lot of power.

An example of a charge-redistribution SAR ADC is described in the MSc thesis of Elzakker, M. van, "Low-power analog-to-digital conversion," MSc Thesis, University of Twente, The Netherlands, Dec 2006. It describes a SAR ADC that runs on an external clock with a frequency equal to the conversion frequency, while using an internal mechanism to provide the successive control signals, based on a delay line.

Furthermore, an example of an asynchronous charge-redistribution SAR ADC using an asynchronous SAR controller is described in Giannini, V. et al, "An 820 W 9b 40MS/s Noise-Tolerant Dynamic-SAR ADC in 90nm Digital CMOS", Solid-State Circuits Conference, 2008, ISSCC 2008, Digest of Technical Papers, IEEE International, IEEE, Piscataway, NJ, USA, 3 February 2008 (2008-02-03), pages 238-239 and 610.

## BRIEF SUMMARY OF THE INVENTION

It is an object of the present invention to provide a SAR ADC with reduced power consumption.

This problem is solved by an asynchronous analog to digital convertor showing the technical features of the characterizing part of the first claim.

Thereto, the control block comprises a plurality of identical bit-slices connected in a chain, the chain comprising an MSB-slice and an LSB-slice interconnected by a plurality of intermediate bit-slices, the bit-slices provided for being activated one after the other, the MSB-slice provided for being activated by the external clock signal, the LSB slice and intermediate bit-slices provided for being activated by a previous bit-slice; each bit-slice comprising a state machine for controlling the comparator to compare the sampled voltage to the reference voltage and for storing the result of the comparison as a bit value in the successive approximation register, and all bit-slices except the LSB slice also for setting the next bit of the successive approximation register and for activating the next bit-slice; each bit-slice comprising dynamic logic with parasitic capacitors for storing each state of the state machine, the dynamic logic being controlled by asynchronous signals.

By using dynamic logic controlled by asynchronous signals as opposed to standard clocked dynamic logic such as domino logic or nora logic using a common clock signal, power losses due to charging and discharging capacitance of the clock-lines and charging and discharging parasitic capacitances of the transistor are avoided. Instead the logic of the present invention is only switched when actually needed, thereby saving power. In addition, asynchronous logic allows signals to be locally generated, so that on average the control lines can be kept shorter, again saving power. It should be mentioned that this form of dynamic logic deviates from traditional "domino logic" or "nora logic" which explicitly uses clock signals.

By providing a structure where individual bit-slices are activated one after the other, only a small part of the complete circuit is actively consuming power. If one large state-machine were used, the entire state-machine would be actively involved for executing the algorithm. Thus power can be saved.

By providing an asynchronous chain that only needs to be initiated by an external clock signal and then runs automatically in a self-timed way, an oversampling clock and corresponding switching losses can be avoided. In addition, high speed operation is provided.

In addition, by using identical bit-slices, design effort can be reduced, and the architecture of the bit-slice optimized. Further, a flexible architecture is provided that can be easily adapted for an analog to digital convertor with a larger or smaller number of bits.

Preferably the state machine comprises a dynamic logic stage with a non-complementary pull-up network and pull-down network connected to a same node, both pull-up network and pull-down network as a means to enable multiple state transitions during the evaluation of the dynamic logic stage, and provided for being controlled only by asynchronous signals.

Providing means for either pulling up or down a node offers flexible asynchronous operation, as it does not need a repeating clock to pre-charge the circuit before every new evaluation of the stage. In particular it allows multiple state transitions of the same stage, as the pull-up function and pull-down function can be activated by different signals. Because of this flexibility the use of a complex control mechanism requiring a lot of logic can be avoided, thus the number of transistors can be reduced, and thus also the power to operate the circuit.

At the beginning of the successive approximation algorithm, the most significant bit (MSB) of the successive approximation register is set to "1" while all other bits are set to "0". This happens once at the start of the clock period. Next, the value of the MSB can change to "0" or remain "1" depending on the comparison made. During the rest of the clock period, successively each other bit is set to "1", and remains "1" or is changed back to "0" depending on the result of the comparison. Thus the MSB can change state once, the other bits will change state once or twice depending on the sampled voltage.

It should be pointed out that such a technique is traditionally highly discouraged because it could potentially lead to shortening the power and ground rails at moments where both the pull-up network and the pull-down network are active at the same time, e.g. because of spikes. The inventor has accepted and minimized that risk by using start- and ready-signals between the different blocks, in order to create a well-defined sequence of events, thereby avoiding spikes.

Preferably the pull-up network and pull-down network are provided for pre-charging the parasitic capacitance on activation of the bit-slice.

This is a clear difference with standard (clocked) dynamic logic where all capacitors are charged simultaneously in one clock phase (the pre-charge phase), and then the function of the stage is evaluated in the other clock phase (the evaluation phase). During that evaluation the value on the capacitor can remain the same, or can change, but it can change only once during a single clock period.

Preferably the successive approximation register is a dynamic register comprising a plurality of parasitic capacitors of the state machines.

By using dynamic logic whereby a capacitor is charged and then left floating while holding its value, power can be saved. By using dynamic logic for holding the bits in the successive approximation register instead of using flip flops, extra power can be saved during the execution of the SAR algorithm.

Preferably the asynchronous analog to digital convertor also comprises a regenerative register for storing the state of the dynamic register after the comparison of the LSB slice is complete, and comprises a standby controller for placing the comparator, the dac and the control block in a standby mode after the transfer of the state of the dynamic register to the static register, and for placing the comparator, the dac and the control block in an active mode again at the beginning of the next external clock period.

By providing a standby controller a large part of the analog to digital convertor can be placed in a low power mode after the algorithm is complete. Before doing so, the value stored in the dynamic register should be copied first to a regenerative register, e.g. flip-flops actively holding the value. Thanks to this standby controller the static power consumption of the ADC is minimized, so that the ADC of the current invention is also very suited for low conversion speeds. By placing the above mentioned blocks in a low power mode automatically and directly after saving the dynamic register value, power savings are maximized. Note that this mechanism also works optimally for a wide range of clock frequencies, or even for a variable clock frequency.

Preferably the state machine of each bit-slice is partitioned as a main state machine with six transistors connected in two stages, and a dac state machine with six transistors connected in a single stage, whereby each parasitic capacitor of each dac state machine is a bit of the successive approximation register.

By partitioning the state machine in two parts, the complexity of each partial state-machine can be minimized. By clever partitioning of the functionality, the risk for spikes or glitches on the asynchronous signals can be minimized, thereby increasing robustness of the system.

## BRIEF DESCRIPTION OF THE DRAWINGS

Presently preferred embodiments are described below in conjunction with the appended drawings, wherein like reference numerals refer to like elements in the various drawings, and wherein:

Fig 1 shows a blockdiagram of a SAR ADC, known in the art.

Fig.2 illustrates a switched capacitor array used in a charge redistribution dac, known in the art.

Fig 3 shows a preferred embodiment of the control block of an asynchronous SAR ADC according to the invention.

Fig 4 shows the control block of Fig 3, with an indication of the control signals of one bit-cycle, corresponding to the timing in Fig 5.

Fig 5 is a timing diagram of one bit-cycle, corresponding to the signals in Fig 4.

Fig 6 shows a simplified view of a comparator, known in the art

Fig 7 shows the gain stages of the comparator of Fig 6.

Fig 8 shows a preferred embodiment of a main control slice for bit(6) according to the invention.

Fig 9 shows the state machine of the main control slice for bit(6), shown in Fig 8.

Fig 10 shows a preferred embodiment of a dac control slice for bit(6) according to the invention.

Fig 11 shows the state machine of the dac control slice for bit(6), shown in Fig 10.

Fig 12A shows a general timing diagram of the SAR ADC of Fig 3.

Fig 12B shows an example of a timing diagram of the SAR ADC of Fig 3, performing four analog to digital conversions.

Fig 13A shows how the chain of main control blocks are reset.

Fig 13B shows the interconnection of three main control blocks in more detail.

Fig 14 shows the state-machine of the standby-controller.

## DETAILED DESCRIPTION

This invention describes the architecture of a low power asynchronous SAR (successive approximation register) ADC (analog to digital convertor). Most drawings are shown for an 8-bit ADC, but the invention is not limited thereto. The person skilled in the art can easily extend or reduce the number of bits of the ADC. The asynchronous SAR ADC proposed in this invention only needs a single external clock 14, with a frequency equal to the sampling frequency.

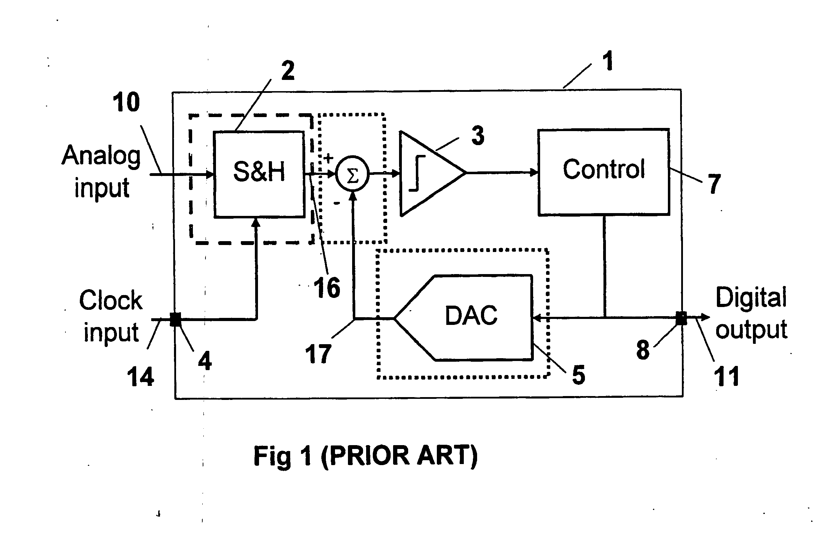

Figure 1 shows a general topology of an n-bit SAR ADC. The analog input 10 is stored in a sample and hold block 2. Then, the stored value 16 is compared against the output of an N-bit DAC 5. Based on the output of the comparison, the control logic tunes the digital input-code of the DAC 5 such that the DAC approximates the analog input 10 as good as possible. A binary search algorithm is employed such that N cycles of the algorithm are required to set the N bits of the DAC correctly. As the DAC output 17 approximates the sampled analog input 16, the digital code of the DAC yields a digital representation of the sampled analog input 16.

The blocks of the SAR ADC 1 can be implemented in several ways. The focus of the invention is on the control block 7, but in order to reach a low power ADC that is preferably also fast, all blocks should be low power and fast. The dac 5 can e.g. be implemented as a switched-capacitor charge-redistribution DAC, but other low power components would also work.

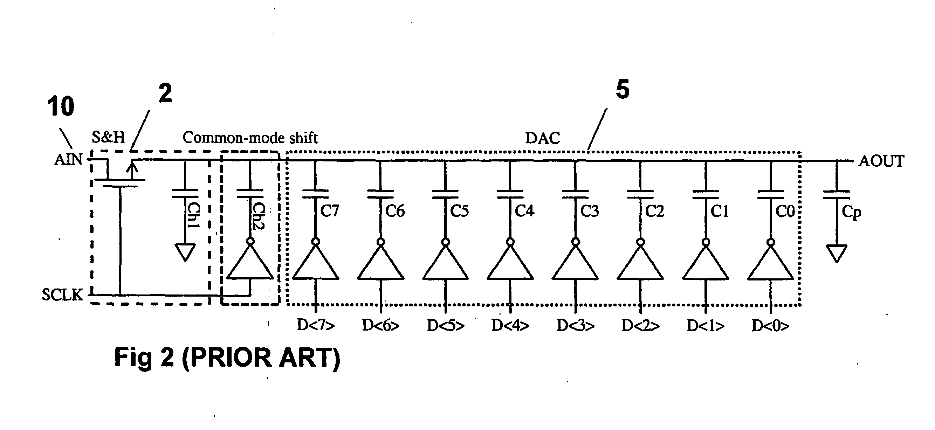

Figure 2 shows an analog block that can be used in an embodiment of the present invention. It comprises a sample and hold block 2 for tracking and holding an analog voltage input 10, a common-mode level shift, and a digital-to-analog convertor 5 based on a switched capacitor array. These components and their functionality are known in the art.

As shown, the sample and hold block 2 can be realised by means of a capacitor and a switch, here implemented by an NMOS transistor and a capacitor array. The total capacitance $C_s = C_{h1} + C_{h2} + C_{dac} + C_p$, where $C_{dac}$ is the sum of $C_0$ up to $C_7$. While the switch is closed, the value on the capacitor tracks the input voltage 10. When the switch is opened, the output Aout provides a discrete-time representation of the continuous-time input signal 10.

Because of the low-voltage operation of the ADC 1, a proper selection of the common-mode level of the analog signal is required to increase the speed of operation. Especially the performance of the S&H block 2 and the comparator 3 are dependent on the common-mode level. The common-mode shift has been implemented with an inverter and a capacitor $C_{h2}$. After the sampling clock 14 goes low to sample the input 10, the inverter-output driving the bottom plate of $C_{h2}$ will go high. This level transition causes a common-mode shift of VDD. $C_{h2}/ C_s$. This technique is known in the art and needs not to be further described here.

Fig 2 also shows a charge-redistribution DAC. The 8-bit digital input code D<7:0>, coming from a successive approximation register 6, not shown here but present in the control block 7, drives the binaryscaled capacitor array $C_0$ - $C_7$ by means of buffers. The buffers are implemented by inverters, switching the bottom capacitor plates between ground (GND) and the supply voltage (VDD). The capacitors are binary weighted. Note that the DAC is driven by the inverted digital input signals.

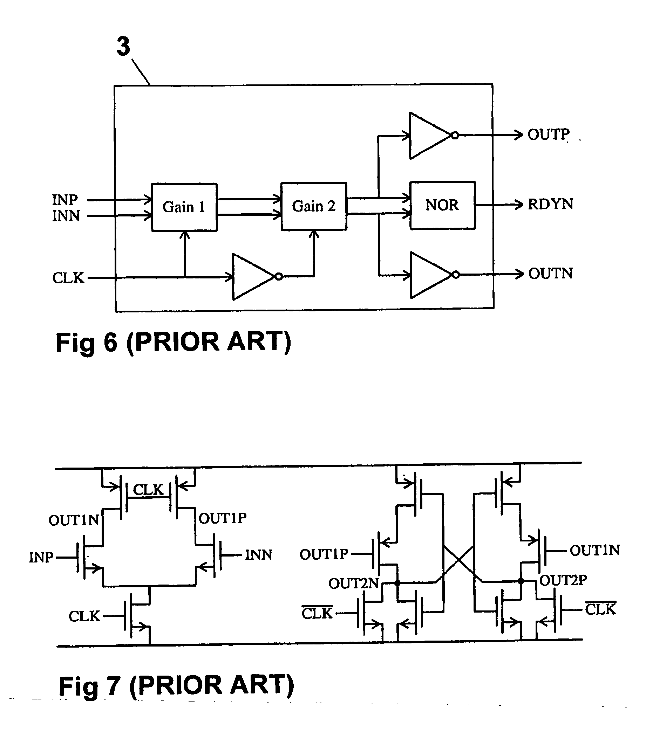

Referring to Fig 6, the comparator described in the thesis of Elzakker is used as a comparator 3 of the preferred embodiment of the SAR ADC 1 of the present invention, but other comparators found suitable by the person skilled in the art can also be used. A comparator with low leakage and high speed is preferred. High speed is achieved by the biasing conditions and asynchronous control logic that advances immediately after completing the comparison. For this purpose a ready-signal (RDYN) is added to indicate completion of the comparison. The trip-point of the NOR gate is adjusted to make sure that the output is valid before the ready-signal (RDYN) goes low.

Fig 6 shows a simplified view of the implemented comparator 3: on the rising edge of the CLK input, (which is an asynchronous signal in the SAR ADC of the present invention), the differential signal input (INP-INN) is processed by two gain stages. The first gain stage provides some pre-gain and shielding of the input from the second stage, which is a regenerative latch. Two (digital) inverters are used to buffer the digital output. Before the actual comparison, both outputs (OUTP, OUTN) will provide a logical high level. As soon as the second gain stage latches, one of the two outputs will go low, dependent on the decision of the comparator. The output RDYN indicates when the comparison is ready and the output is valid: before and during conversion, RDYN provides a logical '1'. As soon as a decision is made, RDYN goes low. This ready-flag (RDYN) is used by the asynchronous state-machine (in the control block 7, described further) to proceed to the next phase of the conversion process. The complete comparator 3 is based on dynamic circuitry, requiring no static bias current.

A more detailed view of the two gain stages of Fig 6 is given in Figure 7. The first stage is a differential pair of which the tail current is turned on when the CLK goes high. The output load is purely capacitive, as the PMOS transistors are turned off when the tail current is turned on. In the reset phase (when the CLK is low), the PMOS transistors precharge the output nodes of the first stage to VDD. When the CLK goes high, the differential pair is enabled and starts to discharge the parasitic capacitance of the output nodes, reducing the voltage level at the output nodes. When a differential input signal is applied, one of the two output nodes will change faster than the other. The second stage contains two inverters in a feedback structure. While the CLK is low, the output nodes are precharged to 0 (OUT2P=0 and OUT2N=0). When the CLK goes up, the inverters remain in the same state until one of the inputs (OUT1P or OUT1N) becomes sufficiently low to enable charging of the output capacitance. Because of the regenerative properties, the output stage will settle in one of two possible states (OUT2P=1 and OUT2N=0) or (OUT2P=0 and OUT2N=1), dependent on the applied differential input voltage. Before and during the conversion, both outputs remain low, while one of them becomes high only after the decision has been made. Therefore a ready-flag can be generated simply by connecting a NOR gate to the output nodes (as shown in Figure 6): the (inverted) ready-flag RDYN is normally high, and switches to low as soon as the conversion is complete. The trip-point (the voltage level at the input at which the NOR gate switches) has been chosen somewhat above the normal value to be sure that the ready signal is not generated too early.

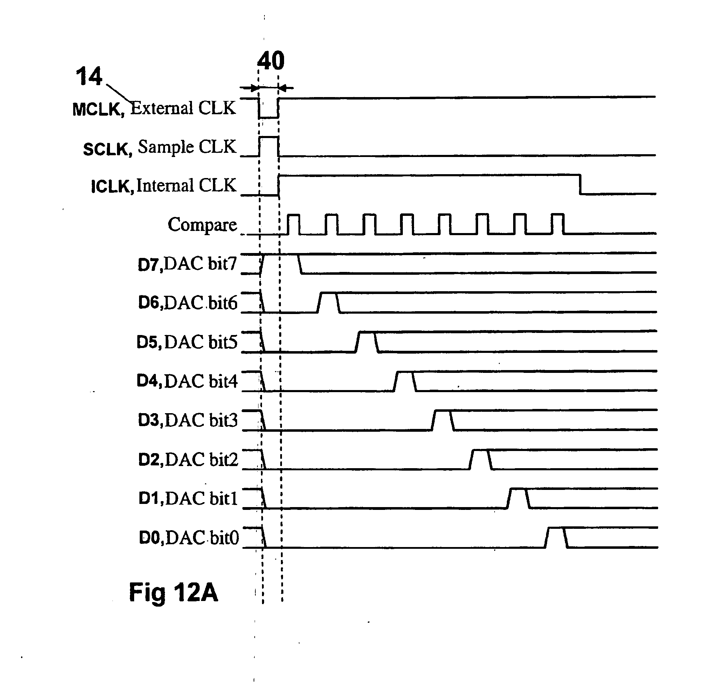

The purpose of the control block of Figure 1 is to synchronize all operations in the ADC. As the ADC works asynchronously, there is no clock to which all operations can be synchronized. Instead, the operations are synchronized by generating start and ready flags between the blocks to indicate whenever an operation is allowed to start and whenever an operation is finished. Figure 12A gives a high level overview of the operations of the ADC in the time domain. A single external clock 14 is used to generate two clock signals internally: the sample clock, used to control the sample and hold circuit 2, and the internal clock ICLK, used to start the A to D conversion. While the external clock 14 is low, the sampler 2 is tracking the analog voltage input 10. As soon as the external clock 14 goes high, the analog value 10 is held on the sampling capacitor and the A to D conversion can start. One by one, starting with the MSB, each bit of the DAC is set to one, a comparison is performed, and based on the result of the comparison the bit of the DAC is kept at one or reset to zero. When all bits of the successive approximation register of the DAC are resolved, the conversion is complete and the internal clock ICLK will go low to enable a low-power standby mode. A new conversion for the next input sample 10 will start at a new external clock cycle 14. Note that DAC bit 7 is set to '1' and all other DAC bits are reset to '0' during the tracking phase 40, which is required to set the DAC 5 to midscale as explained before.

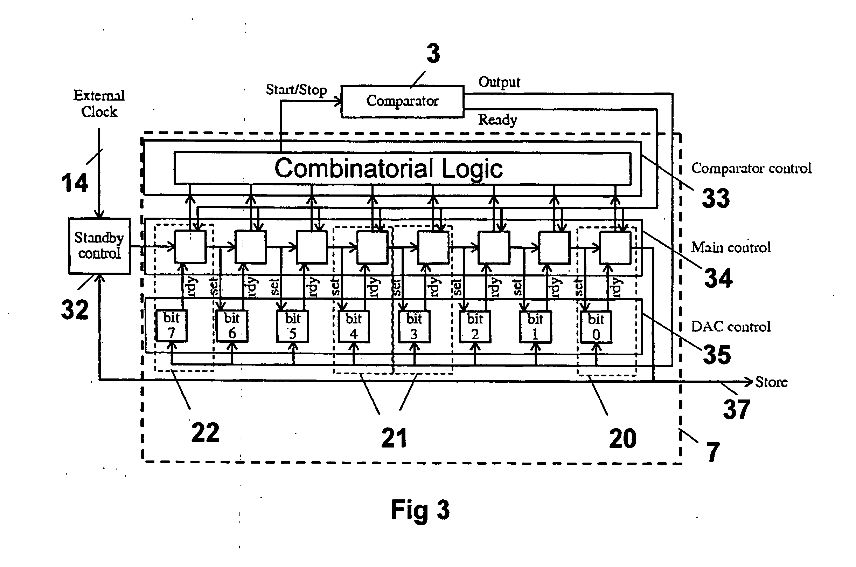

An overview of the digital logic, realizing the algorithm of Figure 12A, is shown in Figure 3. The control block 7 contains several sub-blocks, namely:

- A Standby controller 32 : initiates an A/D conversion when a rising edge of the external clock 14 is applied. When the conversion is completed, the standby controller 32 returns the ADC to a low-power standby mode.
- Main control 34: main state machine 23 of the SAR ADC, controlling the repetitive actions of setting bits in the successive approximation register 6, and controlling comparisons of the sampled voltage and the DAC voltage.
- Comparator control 33: controls the start and stop of the comparator 3 for each bit-cycle 36.
- DAC control 35: controls the elements of the DAC and contains the successive approximation register 6 with the digital output code.

Iteratively, the following operations take place as soon as the standby controller 32 enables the ADC:

1) A bit is set in the DAC control 35, and the next slice 20, 21, 22 in the main control 34 is activated.
2) The DAC control 35 generates a ready flag for the active slice 20, 21, 22 to indicate the bit is set.

3) The active slice 20, 21, 22 generates a start flag for the comparator control 33 to request a new comparison.

4) When the comparison is ready, a ready flag is send back by the comparator 3 to the slice, and the output of the comparison is stored in the successive approximation register 6.

5) The active slice sets the next bit of the successive approximation register 6, and activates the next slice in the chain.

When the last bit is resolved, slice 0 in the DAC controller 35 generates a ready flag for the standby controller 32 to return to standby mode. The same bit is used to generate a store signal 37, which stores the produced output code in the static output register.

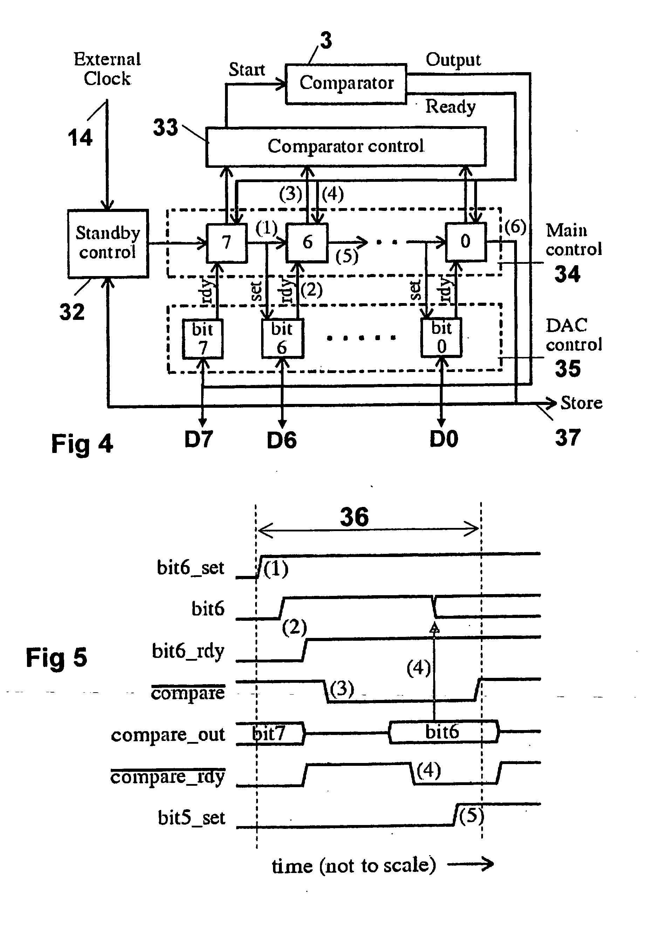

Figure 4 and Figure 5 show in more detail the operation of bit-slice 6. In phase (1), bit 6 of the DAC is set (by bit6_set) and slice 6 of the main control 34 is initiated. When the DAC voltage 5 is settled, a ready signal (bit6_rdy) is forwarded (2). A comparison is requested (3), and when it is ready (4), the result of the comparison is stored into the DAC control and the main control 34 proceeds to the next slice (5). Immediately after the SAR algorithm is finished (6), the digital output code is stored and a feedbacksignal is sent to the standby control 32 to reset the entire logic to a predefined state in which the leakage-power is minimized.

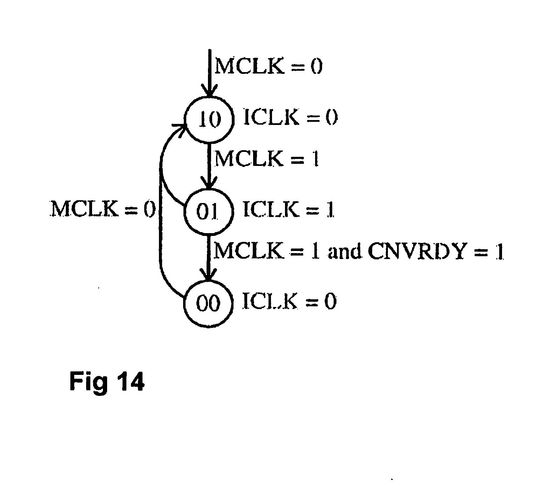

The standby controller 32 implements the state machine shown in Figure 14: when the external clock 14 (MCLK) = 0, the state machine is reset to state 10, and the internal ADC clock ICLK is set to 0. As soon as the external clock 14 goes high, the state changes to 01 and the internal clock will be set to 1 to initiate a A/D-conversion. When the A/D-conversion is finished, the CNVRDY input signal becomes 1 and the ICLK is reset to 0. By resetting ICLK, the other control blocks will be reset to a predefined state, in which the power consumption is minimized. In order to start a new A/D-conversion, the external clock 14 (MCLK) has to go low first in order to reach state 10 and then high again.

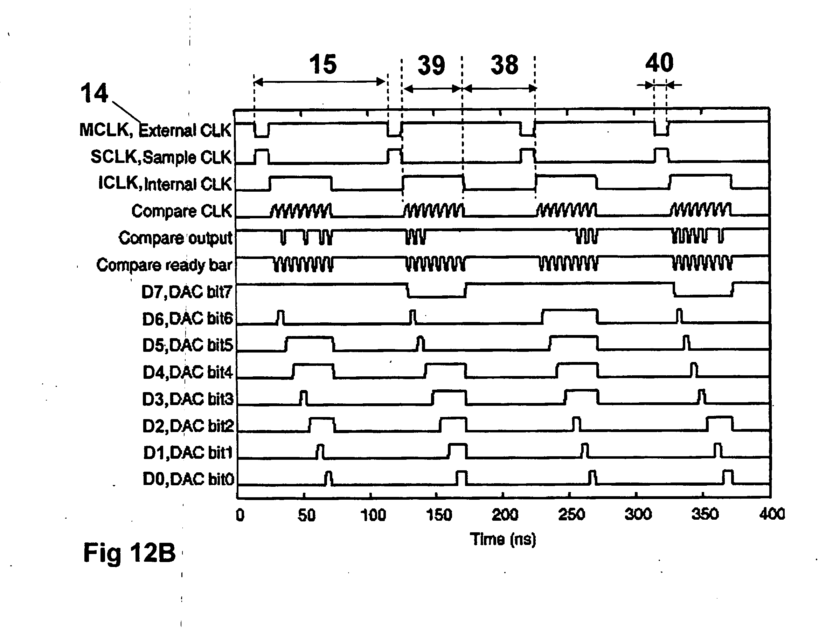

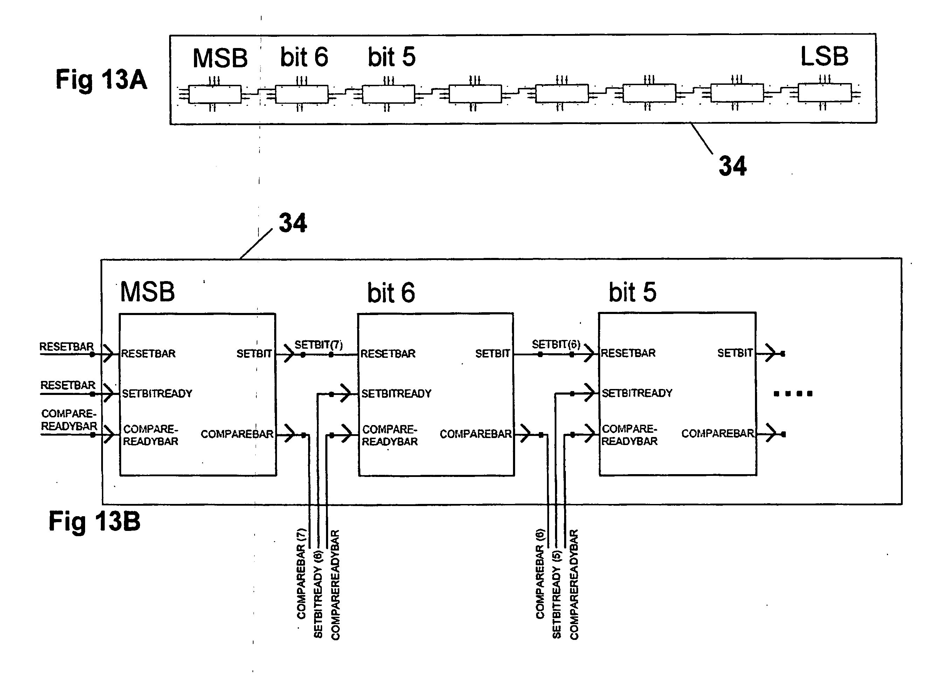

The main control block 34 implements the state machine that synchronizes the eight repetitive bit cycles 36 of the ADC. It is composed of a series of eight slices, one for each bit of the ADC, as indicated in Figure 3 and Figure 13A. During the standby-phase 38 (see Fig 12B), all slices 20, 21, 22 are reset to a predefined state. As soon as the conversion-phase 39 starts, the first slice (MSB slice) 22 will be activated and starts to determine the most significant bit (MSB, bit7) of the digital output code. When the first slice 22 is ready, a ready-signal is forwarded to the second slice 21, which will start its operation to determine bit6. This process is repeated until the last slice (LSB slice) 20 has resolved bit0.

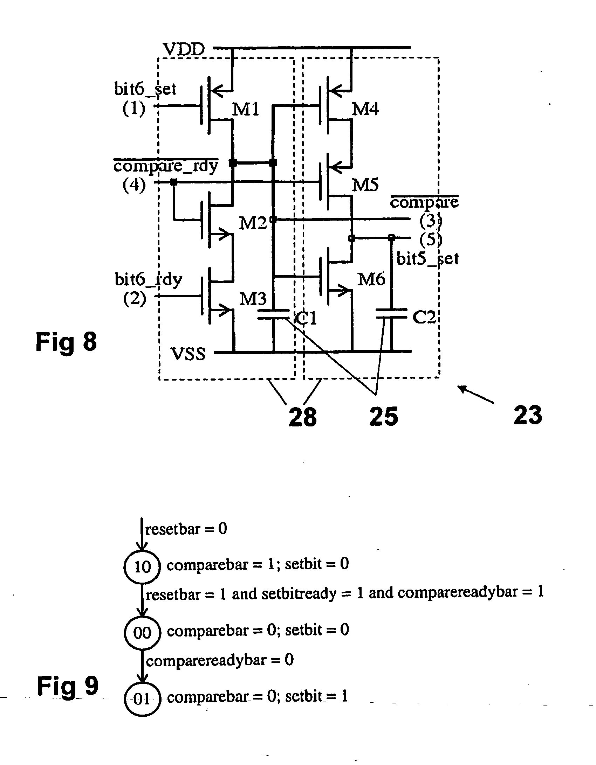

The state machine of a single slice of the main control 34 is shown in Figure 9. The input signals of the state machine are indicated next to the arrows, the output signals next to the state-circles. The three states correspond to the three activities of the slice:

-   When resetbar = 0 (during tracking-phase 40) the state is reset to 10, and the outputs are set to comparebar = 1 and setbit = 0.
-   When resetbar = 1, setbitready = 1 and comparereadybar = 1, the ADC is in the conversion-phase, the bit of the DAC corresponding to this slice has been set and the comparator 3 has been reset after the comparison performed in the previous slice. In this situation, the next comparison can be performed, so the state is advanced to 00, and the comparebar output is changed to 0, indicating to the comparator control 33 that a new comparison can start.
-   When comparereadybar = 0, the comparison is ready. The state changes to 01, which is the final state of the slice. The output setbit is set to 1, which sets the next bit of the DAC to one and indicates to the next slice that it can start its operation.

The behaviour of the first slice 22 (controlling the MSB bit) is slightly different from the other bits as can be seen in Figure 12A and Figure 3: in this specific case the DAC bit (MSB bit) is not reset to zero during the tracking phase 40, but preset to one. Nonetheless, the same hardware is reused to implement this slice; the only difference is the way the input signals are connected.

Note that some signals are implemented in an active-low format, e.g. resetbar and comparereadybar while other signals are implemented in an active-high format, e.g. setbit and setbitready. By doing so, the hardware could be simplified which saves some power.

The implementation of a slice of the main control 34 is given in Figure 8. To save power and high-speed operation, the design is not based on existing complementary cmos logic, or on synchronous clocked dynamic logic such as domino logic or nora logic, but on a custom design style. This significantly reduces the number of gates and the number of transitions, thereby preventing unnecessary charge and discharge operations of the parasitic capacitances. There are two main nodes within this circuit, each having a certain parasitic capacitance, indicated by C1 and C2 in Figure 8. These capacitances are used to store the current state of the state-machine: e.g. state 10 corresponds to a high level on C1 and a low level on C2. In line with Figure 9 and Figure 8, the two outputs of the slice (comparebar and setbit) correspond directly to the state (C1 and C2). As such, no additional output logic is required to derive the output signals from the state. From Figure 9, one can verify the state machine:

-   When resetbar is low, C1 will be charged and C2 will be discharged, resulting in state 10.
-   When resetbar, setbitready and comparereadybar are high, C1 is discharged, obtaining state 00.
-   When the state is 00 and comparereadybar goes low, the state advances to 01.

Note that bit6_set, bit6_rdy and bit5_set in Fig 8 correspond to resetbar, setbitready and setbit in Fig 9 respectively.

While the main control block 34 performs the overall synchronization between the DAC 5 and the comparator 3, the DAC control block (see Figure 3) merely controls the individual bits D7-D0 and it contains the actual successive approximation register 6, which stores the digital output code of the ADC. The DAC control 35 is composed of eight slices 20, 21, 22, each slice controls one bit of the DAC. From Figure 12A it can be observed that in the time-domain, each bit of the DAC passes through three phases (except for the MSB, which skips the first phase):

- A reset phase, in which the bit is set to zero.
- A set phase, in which the bit is set to one, such that the comparison can take place.
- A store phase, in which the decision of the comparison is used to set the definitive output value for this bit (either zero or one).

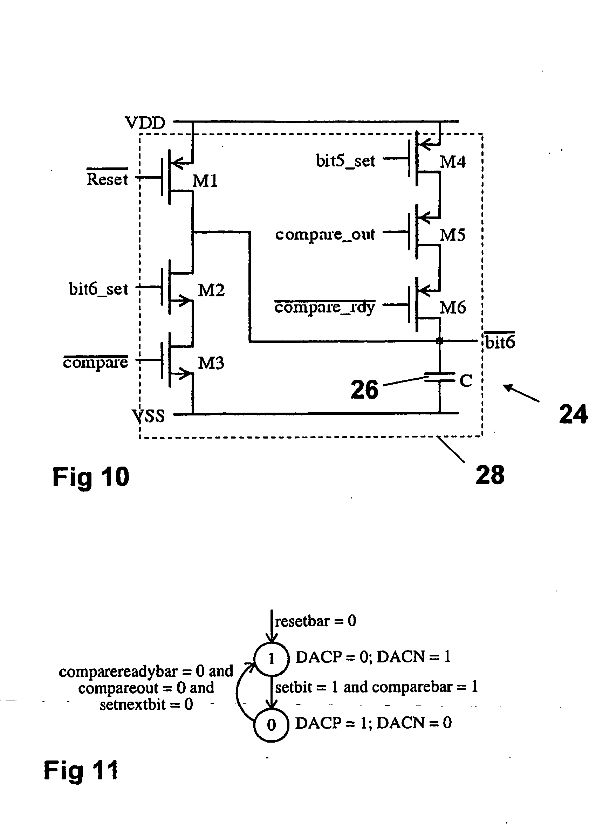

The three phases can be encoded by a two-state state-machine, shown in Figure 11. The state corresponds to the inverse of the value of the bit, and inherently acts as the successive approximation register 6 storing the digital output code of the DAC:

- State 1, in which the bit is set to zero. This corresponds to the reset phase or the store phase when the final bit value equals zero.
- State 0, in which the bit is set to one. This corresponds to the set phase, or the store phase when the final bit value equals one.

Figure 11 shows the state-machine for the dac control, revealing that:

- When resetbar = 0, the state is reset to 1 and the DAC bit is reset to zero.
- When setbit = 1 and comparebar = 1, the main control block 34 indicates that this bit should be set in order to enable the comparison. So, the state is updated to 0, setting the DAC bit to one. The DAC bit is also send back to the main control block 34 (named setbitready), to indicate that the DAC bit has been set.
- When comparereadybar = 0 and compareout = 0 and setnextbit = 0, a comparison is ready and the obtained result equals 0, indicating that the active DAC bit should be reset to zero. As the comparator 3 output is connected to all slices 20, 21, 22 of the DAC control 35, it is necessary to verify which DAC bit should be reset. This is done by checking setnextbit, which is the setbit of the next DAC slice. If it is zero, it means that the current slice is the 'active' one, which should be reset. If the setnextbit = 1, the result of the comparison is meant for another bit of the DAC.

The proposed implementation of a slice of the DAC control 35 is shown in Figure 10: The logic level on the parasitic capacitance C 26 corresponds to the state. Two CMOS inverters are used as output buffers, while the remaining transistors implement the possible transitions of the state-machine according to Figure 11. Note that bit6_set and bit5_set in Fig 10 correspond to setbit and setnextbit in Fig 11 respectively.

The comparator control (Figure 3) is a simple logic function that generates the clock for the comparator 3. This clock should go high whenever a slice 20, 21, 22 of the main control 34 asks for a comparison, which is indicated by a low level on the comparebar output of a slice. Next, the comparator clock should go low as soon as possible to reset the comparator 3 before the next comparison. However, it should not go low before the result of the comparison is processed. As the setbit output of the slice will go high upon receiving the comparereadybar signal, this is a proper indication that the result of the comparison is indeed processed. So, the comparator clock signal should be high as long as comparebar = 0 and setbit = 0. As each slice has its own outputs, the actual comparator clock generated by the comparator control block 33 uses a logical combination over all slices 20, 21, 22, according to the following formula:

$$compare = \sum_{all \ slices \ i} \overline{\overline{comparebar_i} \cdot \overline{setbit_i}}$$

This function was implemented with standard CMOS gates.

During the A/D conversion, the generated digital output code is stored locally in the successive approximation register 6 of the DAC control block 35. However, at the end of the conversion process, the AD converter 1 is reset to standby mode. At that moment, the output code would also be reset. Therefore, an additional regenerative 8-bit register is added in which the digital output code is stored just before the standby mode is activated. This regenerative 8-bit register will not be reset during standby mode, such that the digital output code remains available until a new conversion result is produced. An output clock is also generated to simplify synchronization to the digital output data, in a traditional way. The output register is preferably implemented by a standard 8-bit flip-flop, which latches the input data at the rising edge of the store signal 37. The store signal 37 is generated by the DAC controller 35 as soon as the conversion is ready, as indicated in Figure 3. In a preferred embodiment, the output synchronization clock is derived from the internal clock signal ICLK, and buffered by an inverter.

## Claims

1. An asynchronous analog to digital convertor (1) for converting an analog voltage signal (10) into a digital output (11) comprising a predetermined number of bits, the analog to digital convertor (1) comprising:

   - a clock input (4) for receiving an external clock signal (14) having an external clock period (14);
   - a sample and hold block (2) for sampling the analog voltage signal (10), and storing it as a sampled voltage (16);
   - a comparator (3) connected to the sample and hold block (2), for comparing the sampled voltage (16) to a reference voltage (17);
   - a dac (5) for generating the reference voltage (17) corresponding to a state of a successive approximation register (6);
   - a control block (7) connected to the comparator (3) and to the dac (5) for generating and receiving a sequence of control signals according to a successive approximation algorithm, for performing a plurality of comparisons and for updating the state of the successive approximation register (6);
   - output means (8) for providing the state of the successive approximation register (6) as the digital output (11) after execution of the algorithm;
   **characterised in that**
   - the control block (7) comprises a plurality of identical bit-slices connected in a chain, the chain comprising an MSB-slice (22) and an LSB-slice (20) interconnected by a plurality of intermediate bit-slices (21), the bit-slices provided for being activated one after the other, the MSB-slice (22) provided for being activated by the external clock signal (14), the LSB slice (20) and intermediate bit-slices (21) provided for being activated by a previous bit-slice (20, 21);
   - each bit-slice (20, 21, 22) comprising a state machine (23, 24) for controlling the comparator (3) to compare the sampled voltage (16) to the reference voltage (17) and for storing the result of the comparison as a bit value in the successive approximation register (6), and all bit-slices except the LSB slice also for setting the next bit of the successive approximation register (6) and for activating the next bit-slice (20, 21);
   - each bit-slice (20, 21, 22) comprising dynamic logic with parasitic capacitors (25, 26) for storing each state of the state machine (23, 24), the dynamic logic being controlled by asynchronous signals.

2. An asynchronous analog to digital convertor (1) according to claim 1, **characterised in that** the state machine (23, 24) comprises a dynamic logic stage (28) with a non-complementary pull-up-network and pull-down network connected to a same node, both pull-up network and pull-down network provided as a means to enable multiple state transitions during the evaluation of the dynamic logic stage (28), and provided for being controlled only by asynchronous signals.

3. An asynchronous analog to digital convertor (1) according to claim 2, **characterised in that** the pull-up network and pull-down network are provided for pre-charging the parasitic capacitance on activation of the bit-slice (20, 21, 22).

4. An asynchronous analog to digital convertor (1) according to any one of the previous claims, **characterised in that** the successive approximation register (6) is a dynamic register comprising a plurality of parasitic capacitors (26) of the state machines (24).

5. An asynchronous analog to digital convertor (1) according to claim 4, **characterised in that** the asynchronous analog to digital convertor (1) also comprises a regenerative register for storing the state of the dynamic register (6) after the comparison of the LSB slice (20) is complete, and comprises a standby controller (32) for placing the comparator (3), the dac (5) and the control block (7) in a standby mode after the transfer of the state of the dynamic register to the regenerative register, and for placing the comparator (3), the dac (5) and the control block (7) in an active mode again at the beginning of the next external clock period (15).

6. An asynchronous analog to digital convertor (1) according to anyone of the previous claims, **characterised in that** the dac (5) is a charge redistribution dac comprising a switched capacitor array of binary weighted capacitors.

7. An asynchronous analog to digital convertor (1) according to any one of the previous claims, **characterised in that** the state machine of each bit-slice (20, 21, 22) is partitioned as a main state machine (23) with six transistors connected in two stages, and a dac state machine (24) with six transistors connected in a single stage (28), whereby each parasitic capacitor (26) of each dac state machine (24) is a dynamic register bit.

8. An electronic device comprising an analog to digital convertor according to any one of claims 1-7.

**Patentansprüche**

1. Asynchroner Analog-Digital-Wandler (1) zum Umwandeln eines analogen Spannungssignals (10) in eine digitale Ausgabe (11), die eine vorbestimmte Anzahl von Bits umfasst, wobei der Analog-Digital-Wandler (1) Folgendes umfasst:

- einen Takteingang (4) zum Empfangen eines externen Taktsignals (14) mit einer Periode eines externen Takts (14),
- einen Abtast-Halte-Block (2) zum Abtasten des analogen Spannungssignals (10) und Speichern desselben als abgetastete Spannung (16),
- eine Vergleichsschaltung (3), die an den Abtast-Halte-Block (2) angeschlossen ist, zum Vergleichen der abgetasteten Spannung (16) mit einer Referenzspannung (17),
- einen Digital-Analog-Wandler (5) zum Erzeugen der Referenzspannung (17) entsprechend einem Zustand eines SAR-Registers (Successive Approximation Register) (6),
- einen Steuerblock (7), der an die Vergleichsschaltung (3) und den Digital-Analog-Wandler (5) angeschlossen ist, zum Erzeugen und Empfangen einer Sequenz von Steuersignalen gemäß einem Sukkzessive-Approximation-Algorithmus, um mehrere Vergleiche auszuführen und den Zustand des SAR-Registers (6) zu aktualisieren,
- Ausgabemittel (8) zum Bereitstellen des Zustandes des SAR-Registers (6) als die digitale Ausgabe (11) nach dem Ausführen des Algorithmus,
**dadurch gekennzeichnet, dass**
- der Steuerblock (7) mehrere identische Bit-Slices umfasst, die in Reihe geschaltet sind, wobei die Reihe einen MSB-Slice (22) und einen LSB-Slice (20) umfasst, die durch mehrere Zwischen-Bit-Slices (21) miteinander verbunden sind, wobei die Bit-Slices dafür bereitgestellt sind, nacheinander aktiviert zu werden, der MSB-Slice (22) dafür bereitgestellt ist, durch das externe Taktsignal (14) aktiviert zu werden, der LSB-Slice (20) und die Zwischen-Bit-Slices (21) dafür bereitgestellt sind, durch einen vorherigen Bit-Slice (20, 21) aktiviert zu werden,
- jeder Bit-Slice (20, 21, 22) eine Zustandsmaschine (23, 24) zum Steuern der Vergleichsschaltung (3) umfasst, um die abgetastete Spannung (16) mit der Referenzspannung (17) zu vergleichen und das Ergebnis des Vergleichs als Bit-Wert im SAR-Register (6) zu speichern, und alle Bit-Slices, ausgenommen der LSB-Slice, außerdem zum Festlegen des nächsten Bits des SAR-Registers (6) und zum Aktivieren des nächsten Bit-Slice (20, 21) dienen,
- jeder Bit-Slice (20, 21, 22) eine dynamische Logik mit parasitären Kondensatoren (25, 26) zum Speichern jedes Zustandes der Zustandsmaschine (23, 24) umfasst, wobei die dynamische Logik durch asynchrone Signale gesteuert wird.

2. Asynchroner Analog-Digital-Wandler (1) nach Anspruch 1, **dadurch gekennzeichnet, dass** die Zustandsmaschine (23, 24) eine Dynamische-Logik-Stufe (28) mit nicht komplementärem Pull-Up-Netzwerk und Pull-Down-Netzwerk umfasst, die an den gleichen Knoten angeschlossen sind, wobei sowohl das Pull-Up-Netzwerk als auch das Pull-Down-Netzwerk als Mittel bereitgestellt sind, mehrere Zustandsübergänge während der Bewertung der Dynamische-Logik-Stufe (28) zu ermöglichen, und die nur zur Steuerung durch asynchrone Signale bereitgestellt sind.

3. Asynchroner Analog-Digital-Wandler (1) nach Anspruch 2, **dadurch gekennzeichnet, dass** das Pull-Up-Netzwerk und das Pull-Down-Netzwerk bereitgestellt sind, den parasitären Kondensator nach Aktivierung des Bit-Slice (20, 21, 22) vorzuladen.

4. Asynchroner Analog-Digital-Wandler (1) nach einem der vorhergehenden Ansprüche, **dadurch gekennzeichnet, dass** das SAR-Register (6) ein dynamisches Register ist, das mehrere parasitäre Kondensatoren (26) der Zustandsmaschine (24) umfasst.

5. Asynchroner Analog-Digital-Wandler (1) nach Anspruch 4, **dadurch gekennzeichnet, dass** der asynchrone Analog-Digital-Wandler (1) außerdem ein regenerierendes Register umfasst, um den Zustand des dynamischen Registers (6) nach Abschluss des Vergleichs des LSB-Slice (20) zu speichern, und einen Standby-Controller (32) umfasst, um die Vergleichsschaltung (3), den Digital-Analog-Wandler (5) und den Steuerblock (7) nach Übermittlung des Zustandes des dynamischen Registers an das regenerierende Register in einen Standby-Modus zu versetzen und um die Vergleichsschaltung (3), den Digital-Analog-Wandler (5) und den Steuerblock (7) zu Beginn der nächsten Periode des externen Takts (15) wieder in einen aktiven Modus zu versetzen.

6. Asynchroner Analog-Digital-Wandler (1) nach einem der vorhergehenden Ansprüche, **dadurch gekennzeichnet, dass** der Digital-Analog-Wandler (5) ein Digital-Analog-Wandler mit Ladungsverteilung ist, der eine Schaltkondensatormatrix binär gewichteter Kondensatoren umfasst.

7. Asynchroner Analog-Digital-Wandler (1) nach einem der vorhergehenden Ansprüche, **dadurch gekennzeichnet, dass** die Zustandsmaschine jedes Bit-Slice' (20, 21, 22) als Hauptzustandsmaschine (23) mit sechs Transistoren partitioniert ist, die in zwei Stufen geschaltet sind und als eine Analog-Digital-Wandler-Zustandsmaschine (24) mit sechs Transistoren, die in einer einzelnen Stufe (28) geschaltet sind, wobei jeder parasitäre Kondensator (26) jeder Analog-Digital-Wandler-Zustandsmaschine (24) ein Bit des dynamischen Registers ist.

8. Elektronisches Gerät, das einen Analog-Digital-Wandler nach einem der Ansprüche 1 bis 7 umfasst.

**Revendications**

1. Convertisseur analogique - numérique (1) asynchrone pour convertir un signal de tension analogique (10) en une sortie numérique (11) comprenant un nombre prédéterminé de bits, le convertisseur analogique - numérique (1) comprenant :

    - une entrée d'horloge (4) pour recevoir un signal d'horloge extérieure (14) ayant une période d'horloge extérieure (14) ;
    - un bloc d'échantillonnage et de blocage (2) pour échantillonner le signal de tension analogique (10) et le stocker comme une tension échantillonnée (16) ;
    - un comparateur (3) connecté au bloc d'échantillonnage et de blocage (2) pour comparer la tension échantillonnée (16) à une tension de référence (17) ;
    - un CNA (5) pour générer la tension de référence (17) correspondant à un état d'un registre d'approximations successives (6) ;
    - un bloc de contrôle (7) connecté au comparateur (3) et au CNA (5) pour générer et recevoir une séquence de signaux de contrôle selon un algorithme d'approximations successives, pour effectuer une pluralité de comparaisons et pour actualiser l'état du registre d'approximations successives (6) ;
    - des moyens de sortie (8) pour fournir l'état du registre d'approximations successives (6) comme sortie numérique (11) après exécution de l'algorithme ;
    **caractérisé en ce que**
    - le bloc de contrôle (7) comprend une pluralité de tranches de bits identiques connectées à une chaîne, la chaîne comprenant une tranche MSB (22) et une tranche LSB (20) interconnectées par une pluralité de tranches de bits intermédiaires (21), les tranches de bits étant prévues pour être activées l'une après l'autre, la tranche MSB (22) étant prévue pour être activée par le signal d'horloge extérieure (14), la tranche LSB (20) et les tranches de bits intermédiaires (21) étant prévues pour être activées par une tranche de bits précédente (20, 21) ;
    - chaque tranche de bits (20, 21, 22) comprenant une machine d'états (23, 24) pour contrôler le comparateur (3) pour comparer la tension échantillonnée (16) à la tension de référence (17) et pour stocker le résultat de la comparaison comme une valeur de bit dans le registre d'approximations successives (6), et toutes les tranches de bits, à l'exception de la tranche LSB, servant également pour régler le bit suivant du registre d'approximations successives (6) et pour activer la tranche de bits (20, 21) suivante ;
    - chaque tranche de bits (20, 21, 22) comprenant une logique dynamique avec des condensateurs parasites (25, 26) pour stocker chaque état de la machine d'états (23, 24), la logique dynamique étant contrôlée par des signaux asynchrones.

2. Convertisseur analogique - numérique (1) asynchrone selon la revendication 1, **caractérisé en ce que** la machine d'états (23, 24) comprend un étage de logique dynamique (28) avec un circuit de tirage vers le haut (pull-up) et un circuit de tirage vers le bas (pull-down) non complémentaires connectés à un même noeud, le circuit de tirage vers le haut et le circuit de tirage vers le bas étant prévus comme un moyen pour permettre de multiples transitions d'état pendant l'évaluation de l'étage de logique dynamique (28), et étant prévus pour être contrôlés uniquement par des signaux asynchrones.

3. Convertisseur analogique - numérique (1) asynchrone selon la revendication 2, **caractérisé en ce que** le circuit de tirage vers le haut et le circuit de tirage vers le bas sont prévus pour pré-charger le condensateur parasite lors de l'activation de la tranche de bits (20, 21, 22).

4. Convertisseur analogique - numérique (1) asynchrone selon l'une quelconque des revendications précédentes, **caractérisé en ce que** le registre d'approximations successives (6) est un registre dynamique comprenant une pluralité de condensateurs parasites (26) des machines d'états (24).

5. Convertisseur analogique - numérique (1) asynchrone selon la revendication 4, **caractérisé en ce que** le convertisseur analogique - numérique (1) asynchrone comprend également un registre de régénération pour stocker l'état du registre dynamique (6) quand la comparaison de la tranche LSB (20) est terminée, et comprend un contrôleur de veille (32) pour placer le comparateur (3), le CNA (5) et le bloc de contrôle (7) en mode veille après le transfert de l'état du registre dynamique au registre de régénération, et pour placer de nouveau le comparateur (3), le CNA (5) et le bloc de contrôle (7) en mode actif au début de la période d'horloge extérieure (15) suivante.

**6.** Convertisseur analogique - numérique (1) asynchrone selon l'une quelconque des revendications précédentes, **caractérisé en ce que** le CNA (5) est un CNA de redistribution de charge comprenant un ensemble condensateur commuté de condensateurs binaires pondérés.

**7.** Convertisseur analogique - numérique (1) asynchrone selon l'une quelconque des revendications précédentes, **caractérisé en ce que** la machine d'états de chaque tranche de bits (20, 21, 22) est partitionnée comme une machine d'états principale (23) avec six transistors connectés en deux étages et une machine d'états (24) de CNA avec six transistors connectés en un seul étage (28), chaque condensateur parasite (26) de chaque machine d'états (24) de CNA étant un bit de registre dynamique.

**8.** Dispositif électronique comprenant un convertisseur analogique - numérique selon l'une quelconque des revendications 1 - 7.

Fig 1 (PRIOR ART)

EP 2 296 280 B1

Fig 2 (PRIOR ART)

EP 2 296 280 B1

Fig 3

**3**

External
Clock

Start        Comparator        Output

Ready

**14**

**33**        Comparator control

Standby
control

(3)    (4)

7    (1)    6    (5)    0    (6)    Main
control

**34**

**32**        rdy    set    rdy    (2)    set    rdy

bit
7    bit
6    . . . . .    bit
0    DAC
control

**35**

Store

**Fig 4**    **D7**    **D6**    **D0**    **37**

**36**

bit6_set    (1)

bit6

(2)

bit6_rdy

compare    (3)

(4)

compare_out    bit7    bit6

compare_rdy    (4)

bit5_set    (5)

**Fig 5**

time (not to scale) ⟶

**3**

**Fig 6 (PRIOR ART)**

**Fig 7 (PRIOR ART)**

VDD

bit6_set
(1)

M1

M4

compare_rdy
(4)

M5

M2

compare
(3)

(5)

bit5_set

bit6_rdy
(2)

M3

M6

C1

C2

**Fig 8**

VSS

28    25    23

resetbar = 0

10    comparebar = 1; setbit = 0

resetbar = 1 and setbitready = 1 and comparereadybar = 1

00    comparebar = 0; setbit = 0

comparereadybar = 0

**Fig 9**

01    comparebar = 0; setbit = 1

**Fig 10**

resetbar = 0

DACP = 0; DACN = 1

comparereadybar = 0 and
compareout = 0 and
setnextbit = 0

setbit = 1 and comparebar = 1

DACP = 1; DACN = 0

**Fig 11**

Fig 12A

**Fig 12B**

EP 2 296 280 B1

**Fig 13A**

LSB

MSB  bit 6  bit 5

34

**Fig 13B**

bit 5

bit 6

MSB

34

MCLK = 0

( 10 )  ICLK = 0

MCLK = 1

MCLK = 0  ( 01 )  ICLK = 1

MCLK = 1 and CNVRDY = 1

( 00 )  ICLK = 0

**Fig 14**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **Elzakker, M. van.** Low-power analog-to-digital conversion. MSc Thesis, University of Twente, 2006

- **GIANNINI, V. et al.** An 820 W 9b 40MS/s Noise-Tolerant Dynamic-SAR ADC in 90nm Digital CMOS. *Solid-State Circuits Conference, 2008, ISSCC 2008, Digest of Technical Papers, IEEE International, IEEE, Piscataway, NJ, USA,* 03 February 2008, 238-239610